# EUROPEAN PATENT APPLICATION

(11) **EP 4 632 531 A1**
(43) Date of publication of application: **15.10.2025**
(21) Application number: 23902187.6
(22) Date of filing: 04.09.2023
(51) Int. Cl.: G06F 1/26, H02M 1/00, G06F 1/20

(54) **POWER SOURCE AND COMPUTING DEVICE**

(30) Priority: 16.12.2022 CN 202211636988
(71) Applicant: xFusion Digital Technologies Co., Ltd., Zhengzhou, Henan 450046 (CN)
(72) Inventor: ZHANG, Liangyi, Zhengzhou, Henan 450046 (CN); CHEN, Gang, Zhengzhou, Henan 450046 (CN); LIU, Guoqiang, Zhengzhou, Henan 450046 (CN)
(74) Representative: MERH-IP Matias Erny Reichl Hoffmann Patentanwälte PartG mbB
(86) International application number: PCT/CN2023/116844
(87) International publication number: WO 2024/124981

(57) **Abstract**

Embodiments of the present application provide a power supply and a computing device, which are relate to the field of server technology, and are used for improving a heat dissipation effect of the power supply. The power supply includes a first circuit board, an expansion board, and a plurality of functional components. The first circuit board includes a main body portion and a first plug-in portion located at an end of the main body portion, the first plug-in portion is electrically connectable to an external second circuit board; the expansion board is disposed on the main body portion and electrically connected to the main body portion; a projection of the expansion board on the first circuit board overlaps at least a portion of the first plug-in portion. The plurality of functional components include a first functional component and a second functional component, the first functional component is disposed on the main body portion and electrically connected to the main body portion, and the second functional component is disposed on the expansion board and electrically connected to the expansion board. The above power supply is configured to supply power to the computing device.

## Description

This application claims priority to Chinese Patent Application No. 202211636988.1 filed with the China National Intellectual Property Administration on December 16, 2022, entitled "POWER SUPPLY AND COMPUTING DEVICE", which is incorporated herein by reference in its entirety.

### TECHNICAL FIELD

The present application relates to the field of server technology, and in particular to a power supply and a computing device.

### BACKGROUND

With the emergence of big data, cloud computing, and AI (Artificial Intelligence, artificial intelligence), the computing power requirements for data center servers are increasing. The power consumption of CPUs (Central Processing Units, central processing units) and related components is gradually rising, leading to an escalation in the power of server power supplies from several hundred watts in the past to several thousand watts to meet the power requirements for power components such as CPUs. However, the increasing power of server power supplies leads to poor heat dissipation performance of the server power supplies.

### SUMMARY

Embodiments of the present application aim to provide a power supply and a computing device to improve a heat dissipation effect of the power supply.

To achieve the purpose, the embodiments of the present application adopt the following technical solutions.

In an aspect, a power supply is provided. The power supply includes a first circuit board, an expansion board, and a plurality of functional components. The first circuit board includes a main body portion and a first plug-in portion located at an end of the main body portion, where the first plug-in portion is electrically connectable to an external second circuit board; the expansion board is disposed at the main body portion and electrically connected to the main body portion; where a projection of the expansion board on the first circuit board overlaps at least a portion of the first plug-in portion. The plurality of functional components include a first functional component and a second functional component, where the first functional component is disposed on the main body portion and electrically connected to the main body portion, and the second functional component is disposed on the expansion board and electrically connected to the expansion board.

In the above power supply, the plurality of functional components include a first functional component and a second functional component. A plurality of first functional components are disposed on the first circuit board, and a plurality of second functional components are disposed on the expansion board. By providing the expansion board and disposing some of the functional components, such as the second functional component, on the expansion board, wiring layout space on the first circuit board can be increased, thereby improving the heat dissipation effect of the power supply. In addition, the increased wiring layout space on the first circuit board can also reduce layout difficulty of the functional components in the power supply. In addition, the projection of the expansion board on the first circuit board overlaps at least a portion of the first plug-in portion. However, in related art, space above the first plug-in portion is not in use and remains idle. The above power supply may utilize the space above the first plug-in portion to dispose the expansion board, thereby increasing utilizable space in the power supply, increasing volume of the power supply, reducing a power density, and improving the heat dissipation effect of the power supply. In addition, the increased utilizable space in the power supply can also reduce the layout difficulty of the functional components in the power supply. In addition, by utilizing the space above the first plug-in portion to dispose the expansion board, the volume of the power supply can be increased without expanding space occupied by the power supply on a bottom plate of a chassis body. In the power supply, the power density can be understood as a ratio of a power of the power supply to the volume of the power supply.

In some embodiments, the expansion board includes a first board portion and a second board portion. The first board portion is electrically connected to the second board portion. The first board portion is disposed opposite to the first plug-in portion; and the second board portion is disposed opposite to the main body portion.

An orthogonal projection of the expansion board on the first circuit board may overlap both the first plug-in portion and the main body portion, thereby increasing an area of the expansion board and reducing layout difficulty of the second functional component. In addition, a quantity of the second functional components on the expansion board may be increased, thereby reducing a quantity of the first functional components on the first circuit board, further improving the heat dissipation effect of the power supply.

In some embodiments, the second functional component is disposed on the second board portion; the first board portion is configured as a second plug-in portion, and the second plug-in portion is electrically connectable to the external second circuit board. The first plug-in portion is configured to transmit a power supply signal, and the second plug-in portion is configured to communicate a control signal.

The second plug-in portion for communicating the control signal and the first plug-in portion for transmitting the power supply signal are respectively disposed on the expansion board and the first circuit board, thus allowing a width of the first plug-in portion to be designed greater, thereby increasing a current flow area of the power supply signal.

In some embodiments, the second functional component includes a controller of the power supply.

A control chip may receive the control signal, and based on the control signal, control a first functional component in a voltage processing module.

In some embodiments, the first plug-in portion includes a first plug-in sub-portion and a second plug-in sub-portion, and the first plug-in sub-portion is spaced apart from the second plug-in sub-portion. The first plug-in sub-portion is configured to transmit a power supply signal, and the second plug-in sub-portion is configured to communicate a control signal.

The power supply may be electrically connected to the second circuit board through the first plug-in sub-portion, thereby transmitting the power supply signal to the second circuit board. In addition, the power supply may be electrically connected to the second circuit board through the second plug-in sub-portion, thereby receiving the control signal from the second circuit board.

In some embodiments, there are a plurality of first functional components; at least one of the first functional components is disposed in a target region, and the target region is a region of the main body portion close to the first plug-in portion. The first functional component disposed in the target region includes a first quantity of the first functional component having a height less than a minimum height of a first functional component disposed outside the target region. The expansion board is disposed on a side of the first functional component in the target region facing away from the first circuit board; and the projection of the expansion board on the first circuit board overlaps at least a portion of the second functional component.

A height of any one of the first functional components disposed on the target region is less than a minimum height of a first functional component in other region of the main body portion. Due to a lower height of the first functional component on the target region, after a second board portion of a first expansion board is disposed above the target region, a position of a top of the second functional component can be prevented from being too high after the second functional component is disposed on the first expansion board, resulting in the power supply being too large in size in a direction perpendicular to the first circuit board.

In some embodiments, the power supply further includes an expansion adapter board. The expansion board is disposed at the main body portion via the expansion adapter board, and is electrically connected to the main body portion.

The expansion adapter board may be a circuit board, and some functional components may further be disposed on the expansion adapter board, thereby further increasing the utilizable space in the power supply, reducing the layout difficulty of the functional components, and improving the heat dissipation effect of the power supply.

In some embodiments, the power supply further includes an adapter connector. The expansion board is disposed at the main body portion via the adapter connector, and is electrically connected to the main body portion.

For example, the adapter connector may include a pin. In this case, the expansion board may be electrically connected to the main body portion via the pin.

In another aspect, a computing device is provided. The computing device includes the power supply according to any of the above embodiments and at least one second circuit board. The first plug-in portion is electrically connected to the second circuit board.

The power supply is electrically connected to the second circuit board via the first plug-in portion, thereby supplying power to the components disposed on the second circuit board. For example, the second circuit board may be a mainboard. In addition, the above computing device has a same structure and beneficial technological effect as the power supply provided in some of the above embodiments. The details will not be repeated here.

In some embodiments, the computing device further includes a power adapter board and a first plug-in connector. The power adapter board is electrically connected to the second circuit board; the first plug-in connector is disposed on a side of the power adapter board facing away from the second circuit board, and is electrically connected to the power adapter board; and the first plug-in connector is configured to be plugged into and electrically connected to the first plug-in portion.

The first plug-in portion includes the first plug-in sub-portion and the second plug-in sub-portion, the first plug-in sub-portion is configured to transmit the power supply signal, and the second plug-in sub-portion is configured to communicate the control signal. The first plug-in connector may be plugged into and electrically connected to the first plug-in portion, and the first plug-in connector may be electrically connected to the second circuit board via the power adapter board, thereby allowing the power supply to be electrically connected to the second circuit board and to supply power to the second circuit board and the components disposed on the second circuit board. In this case, the first plug-in connector may communicate the control signal and transmit the power supply signal.

In some embodiments, the computing device further includes a second plug-in connector. The second plug-in connector is disposed on the side of the power adapter board facing away from the second circuit board, and is electrically connected to the power adapter board. The first plug-in connector is spaced apart from the second plug-in connector; and the second plug-in connector is configured to be plugged into and electrically connected to the second plug-in portion.

In a case where the power supply includes the second plug-in portion, the first plug-in portion is configured to transmit the power supply signal, and the second plug-in portion is configured to communicate the control signal. The second plug-in portion is plugged into and electrically connected to the second plug-in connector, and the second plug-in connector may be electrically connected to the power adapter board, so that the second circuit board may communicate the control signal to the second plug-in portion of the power supply.

### BRIEF DESCRIPTION OF DRAWINGS

In order to more clearly illustrate technical solutions in embodiments of the present application, the accompanying drawings to be used in the embodiments of the present application will be described below. Apparently, the drawings in the following description are only drawings of some embodiments of the present application, and other drawings may be obtained according to these drawings for those skilled in the art. In addition, the accompanying drawings in the following description can be regarded as schematic diagrams, and are not intended to limit actual dimensions of products, actual processes of methods, actual timings of signals, or other details related to the embodiments of the present application.
FIG. 1 is a structural schematic diagram of a computing device according to some embodiments;
FIG. 2 is a planar structural schematic diagram of the interior of the computing device according to some embodiments;
FIG. 3 is a structural schematic diagram of a power supply according to some embodiments;
FIG. 4 is a schematic diagram of a structure when a power supply shown in FIG.3 is connected to a second circuit board;
FIG. 5 is a structural schematic diagram of a first circuit board inside a power supply and a first functional component provided on the first circuit board;
FIG. 6 is another structural schematic diagram of a power supply according to some embodiments;
FIG. 7 is a front view of the power supply in FIG. 6;
FIG. 8 is a left view of the power supply in FIG. 6;
FIG. 9 is yet another structural schematic diagram of a power supply according to some embodiments;
FIG. 10 is yet another structural schematic diagram of a power supply according to some embodiments;
FIG. 11 is a structural schematic diagram of a first circuit board in FIG. 10;
FIG. 12 is a planar structural schematic diagram of a first plug-in portion according to some embodiments;
FIG. 13 is a schematic diagram of a structure when the power supply shown in FIG. 10 is electrically connected to a second circuit board;
FIG. 14 is yet another structural schematic diagram of a computing device according to some embodiments;
FIG. 15 is another structural schematic diagram of a power supply according to some embodiments;
FIG. 16 is a planar structural schematic diagram of a first circuit board in FIG. 15;
FIG. 17 is a top view of the first circuit board shown in FIG. 15 connected to an expansion board;
FIG. 18 is a structural schematic diagram of an orthographic projection of a first board portion in FIG. 17 onto a first plug-in portion;
FIG. 19 is yet another structural schematic diagram of a power supply according to some embodiments; and
FIG. 20 is a schematic diagram of a structure when the power supply shown in FIG.19 is electrically connected to a second circuit board.

### DESCRIPTION OF EMBODIMENTS

The following clearly and completely describes technical solutions in embodiments of the present disclosure in combination with accompanying drawings. Apparently, the described embodiments are some but not all of the embodiments of the present disclosure. All other embodiments obtained by those skilled in the art based on the embodiments provided in the present disclosure fall within the scope of protection of the present disclosure.

Unless otherwise specified in the context, in the entire specification and claims, the term "comprise" and its other forms, such as the third-person singular form "comprises" and the present participle form "comprising", are to be interpreted in an open and inclusive sense, that is, "including but not limited to". In the description of the specification, terms such as "some embodiments", "example", or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

Hereinafter, terms "first" and "second" are used only for descriptive purposes, and should not be interpreted as indicating or implying relative importance or implicitly specifying a quantity of indicated technical features. Thus, a feature defined with "first" or "second" may explicitly or implicitly include one or more of such features. Unless otherwise specified in the description of the embodiments of the present disclosure, "a plurality of " represents two or more.

When some embodiments are described, the term "connected" and its derivatives, may be used. The term "connected" should be understood in a broad sense. For example, the term "connected" may represent a fixed connection, a detachable connection, or an integrated connection, or may represent a direct connection or an indirect connection through an intermediary medium. The embodiments disclosed are not necessarily limited to the content of the context.

As used herein, "about" includes a stated value and an average value within an acceptable range of deviation of a specific value, and the acceptable range of deviation is determined by those skilled in the art in consideration of measurement in question and errors associated with measurement of a specific quantity (i.e., limitations of a measurement system).

As used herein, the terms such as "parallel", "perpendicular", and "equal" include a stated condition and a condition similar to the stated condition. A range of the similar condition is within an acceptable range of deviation, and the acceptable range of deviation is determined by those skilled in the art in consideration of measurement in question and errors associated with measurement of a specific quantity (i.e., the limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°. The term "equal" includes absolute equality and approximate equality, and an acceptable range of deviation of the approximate equality may be that, for example, a difference value between the two that are equal is less than or equal to 5% of either of the two.

Exemplary embodiments are described with reference to cross-sectional views and/or plane views as idealized exemplary accompanying drawing. In the accompanying drawings, thicknesses of layers and regions are magnified for clarity. Accordingly, variations from shapes of the accompanying drawings as a result, for example, of manufacturing techniques and/or tolerances, are to be conceivable. Thus, exemplary implementations should not be construed as limited to shapes of regions illustrated herein but are to include deviations in shapes that result, for example, from manufacturing. For example, an etching region illustrated as a rectangle generally have curved features. Thus, the regions illustrated in the accompanying drawings are schematic in nature and their shapes are not intended to illustrate an actual shape of a region of a device and are not intended to limit the scope of the exemplary implementations.

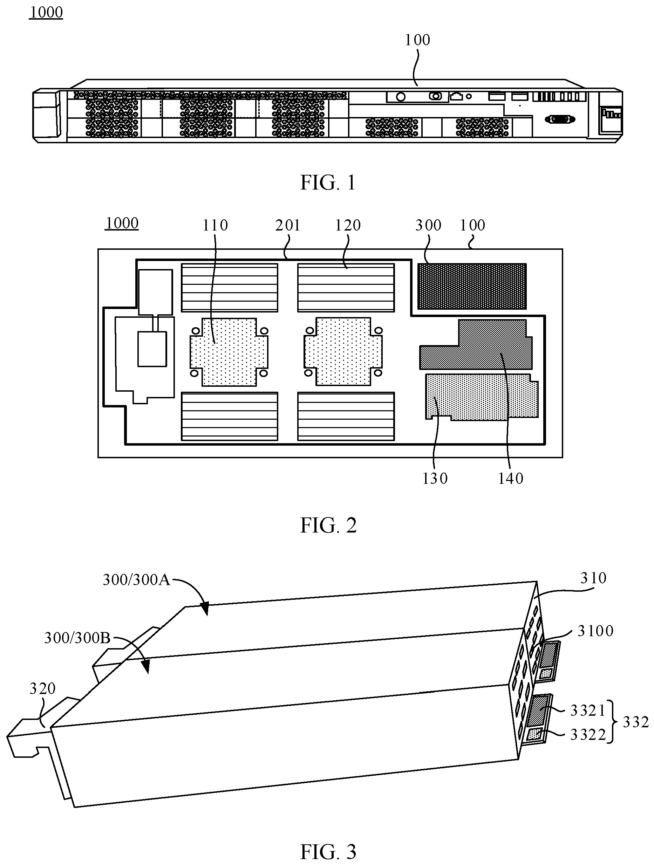

FIG. 1 is a structural schematic diagram of a computing device according to some embodiments.

As shown in FIG. 1, some embodiments of the present application provide a computing device 1000. For example, the computing device 1000 may be a general-purpose computing device or a special-purpose computing device. For example, the computing device 1000 may be a server, a switch, a laptop, a portable computer, a personal digital assistant (Personal Digital Assistant, PDA), a mobile phone, a tablet, a wireless terminal device, a communication device, an embedded device, etc. The type of the computing device 1000 is not limited in embodiments of the present application.

As shown in FIG. 1, by taking the computing device 1000 as a server for example, the computing device 1000 is illustrated.

References can be made to FIG. 1. The computing device 1000 includes a chassis body 100, a plurality of power components (not shown in FIG. 1), and a power supply (not shown in FIG. 1). The chassis body 100 includes accommodation space, and the plurality of power components and the power supply may be disposed within the accommodation space of the chassis body 100. The power supply may supply power to the plurality of power components.

For example, the chassis body 100 may include a main body and a cover body. The main body and the cover body are cooperatively connected to each other to enclose the accommodation space. The connection between the main body and the cover body may be a detachable connection. In this case, opening the cover body may expose various components within the main body. The connection between the main body and the cover body may be a snap-fit connection. In addition, the main body and the cover body may be detachably connected by structures such as screws, bolts, and pins.

For example, the main body may include a bottom plate and a plurality of side plates. The plurality of side plates may be configured along an edge of the bottom plate, and the plurality of side plates may be perpendicular to the bottom plate, with the bottom plate and the cover body being respectively disposed on opposite two sides of the plurality of side plates.

For example, power components may include a CPU (Central Processing Unit, central processing unit), a GPU (Graphics Processing Unit, graphics processing unit), a memory, a network interface card, a PCIE (Peripheral Component Interconnect Express, peripheral component interconnect express) card, a drive, etc., which will not be exhaustively enumerated herein.

FIG. 2 is a planar structural schematic diagram of the interior of the computing device 1000 according to some embodiments.

As shown in FIG. 2, a CPU 110, a memory 120, a network interface card 130, and a PCIE card 140 are disposed on a mainboard 201. The mainboard 201 may be disposed on the bottom plate.

A power supply 300 may be electrically connected to the mainboard 201, thereby supplying power to the plurality of power components disposed on the mainboard 201.

In some examples, in the computing device 1000, a quantity of the power supplies 300 may be a plurality. For example, the quantity of the power supplies 300 is two.

For example, the plurality of power supplies 300 may be disposed side by side on the bottom plate.

In another example, the plurality of power supplies 300 may be stacked, a lowermost power supply 300 among which is disposed on the bottom plate.

FIG. 3 is a structural schematic diagram of a power supply 300 according to some embodiments. In FIG. 3, two power supplies 300 are shown, and the two power supplies 300 in FIG. 3 may be disposed side by side on the bottom plate of the chassis body 100. For example, the two power supplies 300 are respectively a first power supply 300A and a second power supply 300B.

As shown in FIG. 3, the power supply 300 may include a housing 310, a power supply input interface 320, a first plug-in portion 332, and a plurality of functional components (not shown in the figure) disposed in the housing 310.

In some examples, the power supply input interface 320 and the first plug-in portion 332 may be respectively disposed on opposite two sides of the housing 310.

In some examples, the housing 310 includes a plurality of plate members, and the first plug-in portion 332 may protrude from one of the plate members. For example, the first plug-in portion 332 protrudes from a designated plate member, and the designated plate member is provided with a plurality of heat dissipation openings 3100 thereon, thereby facilitating heat dissipation of the power supply 300.

In some examples, a fan may also be provided within the housing 310. The fan may generate an airflow to dissipate heat generated by the power supply 300, thereby enhancing heat dissipation effect of the power supply 300. The airflow generated by the fan may be blown out from the heat dissipation opening 3100.

The power supply input interface 320 may be disposed on a side of the housing 310. The power supply input interface 320 may be electrically connected to an external alternating current power supply to input external alternating current.

The power supply 300 may include a voltage processing module and a control module. It is understandable that the power supply 300 includes the plurality of functional components. For example, some of the functional components may form the voltage processing module, and some of the functional components may form the control module.

The power supply input interface 320 may be electrically connected to the voltage processing module. The voltage processing module may process alternating current and convert the alternating current into direct current required by a target apparatus.

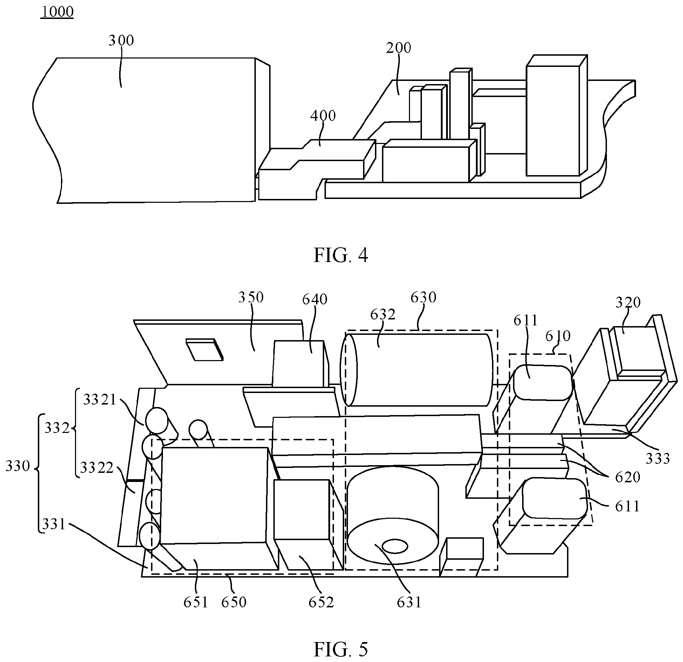

FIG. 4 is a schematic diagram of a structure when the power supply 300 shown in FIG.3 is connected to a second circuit board 200.

As shown in FIG. 4, the first plug-in portion 332 may be electrically connected to a power processing module, and the first plug-in portion 332 may also be electrically connected to the second circuit board 200 (i.e., the target apparatus) outside the power supply 300, so that a power supply signal required by the second circuit board 200 is delivered to the second circuit board 200 to enable the power supply 300 to supply power to components requiring power supply on the second circuit board 200. For example, the second circuit board 200 may be the mainboard 201 (as shown in FIG. 2).

The control module may be electrically connected to the voltage processing module. The control module may generate a control signal, and control the voltage processing module based on the control signal. For example, the first plug-in portion 332 may also be electrically connected to the control module, so that the control module may perform control signal interaction with the second circuit board 200 via the first plug-in portion 332. For example, the control signal may originate from a BMC (Baseboard Management Controller, baseboard management controller) and/or CPLD (Complex Programmable Logic Device, complex programmable logic device) disposed on the mainboard 201.

As shown in FIG. 4, the computing device 1000 may also include a plug-in connector 400. One end of the plug-in connector 400 may be electrically connected to the second circuit board 200, and the other end thereof may be plugged into and electrically connected to the first plug-in portion 332 (as shown in FIG. 3). Consequently, the power supply 300 may be electrically connected to the second circuit board 200 via the first plug-in portion 332 and the plug-in connector 400.

In this case, as shown in FIG. 4, space above the first plug-in portion 332 (as shown in FIG. 3) and the plug-in connector 400 is not provided with any other components, and is in an idle state.

FIG. 5 is a structural schematic diagram of a first circuit board inside the power supply 300 and the functional component provided on the first circuit board.

As shown in FIG. 5, the power supply 300 may also include a first circuit board 330. The first circuit board 330 includes a main body portion 331 and a first plug-in portion 332 located at an end of the main body portion 331. The power supply input interface 320 is electrically connected to the main body portion 331. The plurality of functional components may be disposed on the main body portion 331. The first plug-in portion 332 may be electrically connected to the second circuit board 200 (as shown in FIG. 2), so that the power supply 300 may supply power to a plurality of components on the second circuit board 200.

In some examples, the first circuit board 330 may also include an input portion 333. The input portion 333 may extend from an accommodation cavity enclosed by the housing 310 (as shown in FIG. 2). The power supply input interface 320 (as shown in FIG. 3) may be disposed on the input portion 333. For example, the input portion 333 may be located on a side of the main body portion 331 away from the first plug-in portion 332.

For example, the voltage processing module may include the plurality of functional components. For example, the plurality of functional components may include a filter circuit 610, a rectifier circuit 620, a power factor correction (Power Factor Correction, PFC) circuit 630, a soft-start circuit 640, and a DC-DC conversion circuit 650.

The first circuit board 330 is provided with a conductive trace. The plurality of functional components on the first circuit board 330 may be electrically interconnected via the conductive trace.

The filter circuit 610 may be electrically connected to the power supply input interface 320. The filter circuit 610 may filter a burst pulse and a high-frequency interference from an alternating current signal received by the power supply input interface 320 and reduce an electromagnetic interference generated by the power supply 300 on a power grid. For example, the filter circuit 610 may include a two-stage common-mode inductor 611, and the two-stage common-mode inductor 611 may include two inductors connected in series.

The rectifier circuit 620 may be electrically connected to the filter circuit 610, and the power factor correction circuit 630 may be electrically connected to the rectifier circuit 620. The rectifier circuit 620 may operate in conjunction with the power factor correction circuit 630 to improve a power factor of the power supply 300.

For example, the rectifier circuit 620 may include a half-wave rectifier circuit or a full-wave rectifier circuit.

For example, the power factor correction circuit 630 may include an electronic element such as a switching transistor, an inductor 631, and a capacitor 632.

The soft-start circuit 640 may operate in conjunction with the DC-DC conversion circuit 650 to convert a high-voltage alternating current signal into a low-voltage direct current signal. For example, the soft-start circuit 640 and the DC-DC conversion circuit 650 may convert the high-voltage alternating current signal into a 12V low-voltage direct current signal.

For example, the DC-DC conversion circuit 650 includes a transformer 651 and a resonant inductor 652.

In related technologies, the first circuit board 330 is not only provided with the plurality of functional components in the voltage processing module, but also provided with the control module and a peripheral circuit of the control module, resulting in a high power density of the power supply 300, thereby leading to a poor heat dissipation effect of the power supply 300. In the power supply 300, the power density can be understood as a ratio of a power of the power supply 300 to a volume of the power supply 300.

Based on this, some embodiments of the present application provide the power supply 300.

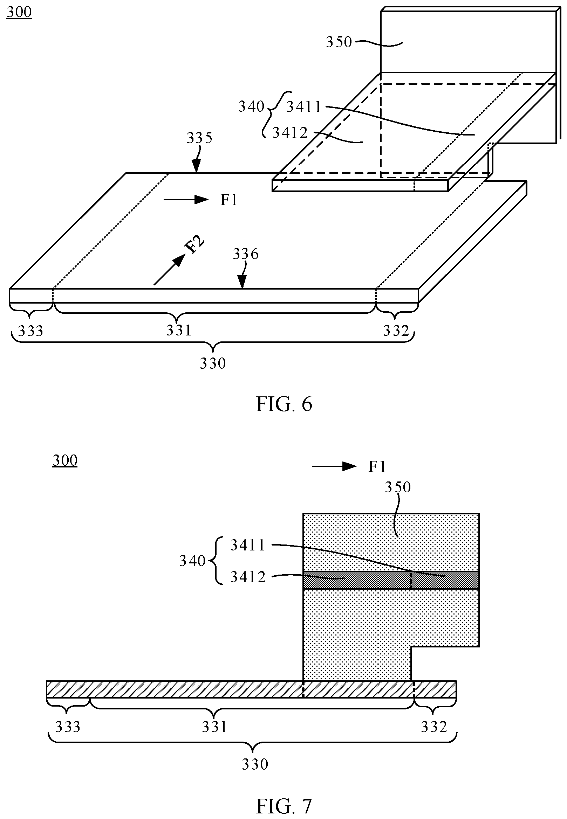

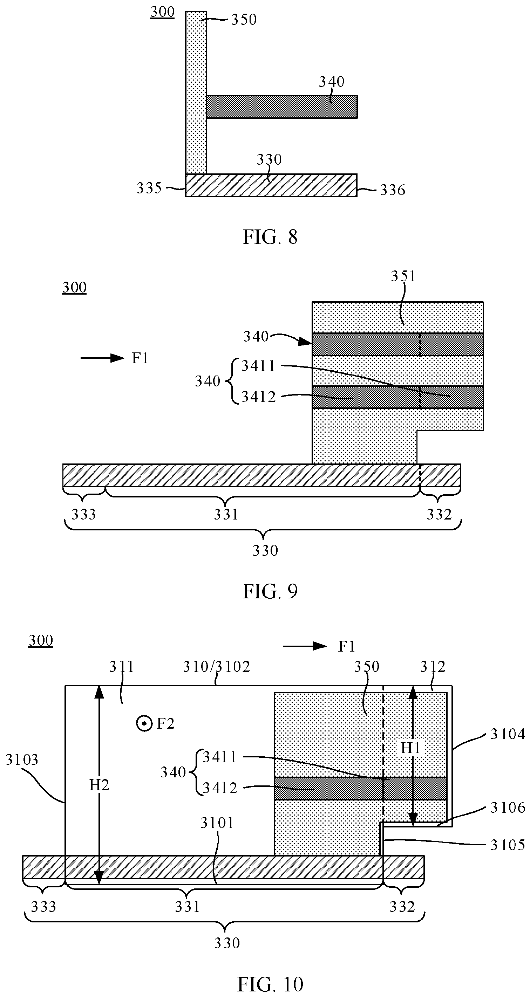

FIG. 6 is another structural schematic diagram of the power supply 300 according to some embodiments. FIG. 7 is a front view of the power supply 300 in FIG. 6. FIG. 8 is a left view of the power supply 300 in FIG. 6.

As shown in FIGS. 6, 7, and 8, the power supply 300 includes a first circuit board 330, an expansion board 340, and a plurality of functional components (not shown in the figures).

The first circuit board 330 includes the main body portion 331 and the first plug-in portion 332. The expansion board 340 is disposed at the main body portion 331 and electrically connected to the main body portion 331. For example, the expansion board 340 may be electrically connected to the first circuit board 330 via an adapter connector. For another example, the expansion board 340 may be electrically connected to the first circuit board 330 via an expansion adapter board 350.

The plurality of functional components include a first functional component and a second functional component. The first functional component is disposed on the main body portion 331 and electrically connected to the main body portion 331. The second functional component is disposed on the expansion board 340 and electrically connected to the expansion board 340.

In some examples, a quantity of the first functional components is a plurality, and the plurality of first functional components are used to form the voltage processing module. For example, the plurality of first functional components may include the filter circuit 610, the rectifier circuit 620, the power factor correction circuit 630, the soft-start circuit 640, and the DC-DC conversion circuit 650.

In some of the embodiments described above, the first circuit board 330 and the voltage processing module disposed on the first circuit board 330 are introduced, and will not be repeated here.

In some examples, the second functional component may be used for the control module. For example, a quantity of the second functional components may be a plurality, and the plurality of second functional components include a controller of the power supply 300. For example, the controller of the power supply 300 may include a plurality of control chips. The controller of power supply 300 may generate a control signal and send the control signal to the voltage processing module to control the first functional component in the voltage processing module. For example, the control signal may include a power supply status signal, a presence signal, a power signal, etc. For example, the control signal may be a low-speed signal. For example, the control signal may be communicated via an I2C (Inter-Integrated Circuit, Inter-Integrated Circuit) bus.

In addition, the second functional component may also include a resistor and a switching transistor operated in conjunction with the controller of the power supply 300.

The expansion board 340 is provided with a conductive trace. The plurality of second functional components disposed on the expansion board 340 may be interconnected via the conductive trace in the expansion board 340.

The second functional component may be disposed on a side of the expansion board 340 facing away from the first circuit board 330.

In FIGS. 6 to 8, there may be one expansion board 340.

FIG. 9 is yet another structural schematic diagram of the power supply 300 according to some embodiments.

As shown in FIG. 9, there may be a plurality of expansion boards 340. For example, the quantity of the expansion boards 340 may be 2, 3, 4, and so on, which will not be listed one by one here. In FIG. 9, some embodiments of the present application are illustrated by taking the quantity of expansion boards 340 as two for example.

For example, the expansion board 340 may be disposed in parallel to the first circuit board 330. When the quantity of the expansion boards 340 is a plurality, the plurality of expansion boards 340 may be disposed in parallel to the first circuit board 330.

In some embodiments of the present application, by providing the expansion board 340 and disposing some of the functional components, such as the second functional component, on the expansion board 340, wiring layout space on the first circuit board 330 can be increased, thereby improving the heat dissipation effect of the power supply 300. In addition, the increased wiring layout space on the first circuit board 330 also reduces layout difficulty of the functional components within the power supply 300.

In addition, a projection of the expansion board 340 on the first circuit board 330 overlaps at least a portion of the first plug-in portion 332. In some examples, an orthographic projection of the expansion board 340 on the first circuit board 330 may completely overlap the first plug-in portion 332. In another example, the orthographic projection of the expansion board 340 on the first circuit board 330 may overlap a portion of the first plug-in portion 332.

In this case, the expansion board 340 may be disposed above the first plug-in portion 332. "Above the first plug-in portion 332" refers to a side of the first plug-in portion 332 facing away from the bottom plate of the chassis body 100.

In conventional technologies, space above the first plug-in portion 332 is not in use and remains idle. In some embodiments of the present application, the expansion board 340 may be disposed in the space above the first plug-in portion 332, thereby increassing utilizable space in the power supply 300, increasing the volume of the power supply 300, reducing the power density, and improving the heat dissipation effect of the power supply 300. In addition, the increased utilizable space in the power supply 300 may also reduce the layout difficulty of the functional components in the power supply 300.

In addition, by utilizing the space above the first plug-in portion 332 to dispose the expansion board 340, the volume of the power supply 300 can be increased without expanding space occupied by the power supply 300 on the bottom plate of the chassis body 100.

As shown in FIGS. 6 to 8, in some other examples, the power supply 300 further includes the expansion adapter board 350. The expansion board 340 is disposed at the main body portion 331 via the expansion adapter board 350, and is electrically connected to the main body portion 331. The expansion adapter board 350 may be a circuit board.

A direction from the main body portion 331 toward the first plug-in portion 332 is a first direction F1. A second direction F2 is perpendicular to the first direction F1 and parallel to the first circuit board 330.

The first circuit board 330 may include a first edge 335 and a second edge 336 which are disposed opposite to each other in the second direction F2. The first plug-in portion 332 is strip-shaped, and an extension direction of the first plug-in portion 332 intersects with extension directions of the first edge 335 and the second edge 336. For example, the first plug-in portion 332 extends along the second direction F2, and the first edge 335 and the second edge 336 may extend along the first direction F1.

The expansion adapter board 350 may be disposed at a side of the first circuit board 330. For example, the expansion adapter board 350 may be disposed along the first edge 335 or the second edge 336. For example, the expansion adapter board 350 may be parallel to the first direction F1. In this case, a side of the expansion adapter board 350 connected to the first circuit board 330 may extend along the first direction F1.

For example, the expansion adapter board 350 may be perpendicular to the first circuit board 330, and the expansion board 340 may be perpendicular to the expansion adapter board 350.

In some examples, a first connection socket may be disposed on one of the expansion adapter board 350 and the first circuit board 330, and a first connection plug may be disposed on the other. The first connection plug may be plugged into and electrically connected to the first connection socket, so that the expansion adapter board 350 is fixed relative to and electrically connected to the first circuit board 330.

In some examples, a second connection socket may be disposed on one of the expansion adapter board 350 and the expansion board 340, and a second connection plug may be disposed on the other. The second connection plug may be plugged into and electrically connected to the second connection socket, so that the expansion adapter board 350 is fixed relative to and electrically connected to the expansion board 340.

In some embodiments, a support column may also be disposed on the first circuit board 330. A threaded hole may be disposed in a side of the support column away from the first circuit board 330, and a mounting hole may be disposed in the expansion board 340. A fastener may pass through the mounting hole and be threaded into the threaded hole, so that the expansion board 340 is fixed relative to the first circuit board 330. This configuration enhances mounting stability of the expansion board 340, and avoids unstable mounting of the expansion board 340.

In some examples, the plurality of functional components may further include a third functional component. The third functional component may be disposed on the expansion adapter board 350. By disposing the third functional component on the expansion adapter board 350, the utilizable space in the power supply 300 can be increased, thereby reducing the power density of the power supply 300 and improving the heat dissipation effect of the power supply 300.

The third functional component may include the controller of the power supply 300 and at least a portion of a peripheral circuit.

In some examples, the power supply 300 may further include a vertical plate. The vertical plate may be fixed relative to and electrically connected to the first circuit board 330. For example, the vertical plate and the expansion adapter board 350 may be respectively disposed along the first edge 335 and the second edge 336. The vertical plate may be a circuit board. For example, the vertical plate may be perpendicular to the first circuit board 330. Some of the plurality of second functional components may also be disposed on the vertical plate. By disposing the vertical plate in the power supply 300, the utilizable space in the power supply 300 can be further increased, thereby reducing a quantity of the functional components on the first circuit board 330 and improving the heat dissipation effect of the power supply 300.

In some embodiments, the power supply 300 may also include a fixing member. The fixing member may be fixedly connected to the housing 310. " The fixing member may be fixedly connected to the housing 310" means that after the fixing member is connected to the housing 310, the two are relatively fixed and their relative positional relation does not change. For example, the fixing member may be connected to the housing 310 by welding, snap-fit connection, or similar methods.

The fixing member may also be fixedly connected to the expansion board 340, thereby fixing the expansion board 340. For example, the fixing member may be connected to the expansion board 340 by a structure such as a screw, a bolt, etc.

In some of the above embodiments, the expansion board 340 is electrically connected to the first circuit board 330 by the expansion adapter board 350. In other embodiments, the expansion board 340 may also be connected to the first circuit board 330 through the adapter connector.

In some examples, the power supply 300 further includes the adapter connector. The expansion board 340 is disposed at the main body portion 331 via the adapter connector, and is electrically connected to the main body portion 331. For example, the adapter connector may be a pin. In this case, the pin may be disposed on the expansion board 340. For another example, the adapter connector may include a connection plug-in portion and a connection slot. One of the connection plug-in portion and the connection slot may be disposed on the expansion board 340, and electrically connected to the expansion board 340, while the other of the connection slot may be disposed on the first circuit board 330, and electrically connected to the first circuit board 330. The connection plug-in portion may be plugged into the connection slot, and electrically connected to the connection slot, thereby achieving an electrical connection between the first circuit board 330 and the expansion board 340.

As shown in FIGS. 6 and 7, in some embodiments, the expansion board 340 includes a first board portion 3411 and a second board portion 3412. The first board portion 3411 is electrically connected to the second board portion 3412. The first board portion 3411 is disposed opposite to the first plug-in portion 332, and the second board portion 3412 is disposed opposite to the main body portion 331.

An orthographic projection of the first board portion 3411 on the first circuit board 330 does not overlap the main body portion 331 but overlaps the first plug-in portion 332.

An orthographic projection of the second board portion 3412 on the first circuit board 330 overlaps a portion of the main body portion 331 and does not overlap the first plug-in portion 332.

The first board portion 3411 is disposed opposite to the first plug-in portion 332, and the second board portion 3412 is disposed opposite to the main body portion 331. Therefore, an orthographic projection of the expansion board 340 on the first circuit board 330 can overlap the first plug-in portion 332 and the main body portion 331, thereby increasing an area of the expansion board 340 and reducing the layout difficulty of the second functional component. In addition, the quantity of the second functional components on the expansion board 340 can be increased, thereby reducing the quantity of the first functional components on the first circuit board 330, further improving the heat dissipation effect of the power supply 300.

FIG. 10 is yet another structural schematic diagram of the power supply 300 according to some embodiments.

As shown in FIG. 10, in some examples, the first board portion 3411 and the second board portion 3412 are located within the housing 310. In this case, the plurality of second functional components may be disposed on the first board portion 3411 and the second board portion 3412.

In some embodiments, the accommodation cavity enclosed by the housing 310 includes a first accommodation cavity 311 and a second accommodation cavity 312, which are sequentially disposed and interconnected along the first direction F1. The first direction F1 extends from the main body portion 331 toward the first plug-in portion 332. As shown in FIG. 6, a direction indicated by an arrow F1 is the first direction.

The main body portion 331 is disposed in the first accommodation cavity 311, and the first plug-in portion 332 extends out of the first accommodation cavity 311. The input portion 333, provided with the power supply input interface 320 (as shown in FIG. 3), is located outside the housing 310 and on a side of the first accommodation cavity 311 facing away from the first plug-in portion 332.

The second accommodation cavity 312 is spaced apart from the first plug-in portion 332 in a direction perpendicular to the first circuit board 330. A portion of the expansion board 340, whose orthographic projection on the first circuit board 330 covers the first plug-in portion 332, is located within the second accommodation cavity 312. For example, the first board portion 3411 is located within the second accommodation cavity 312.

A dimension H1 of the second accommodation cavity 312 in the direction perpendicular to the first circuit board 330 is less than a dimension H2 of the first accommodation cavity 311 in the direction perpendicular to the first circuit board 330.

In some examples, the housing 310 includes a first plate body 3101 and a second plate body 3102 which are disposed opposite to each other. The first circuit board 330 may be disposed on the first plate body 3101, and a width of the first plate body 3101 in the first direction F1 is less than a width of the second plate body 3102 in the first direction F1.

The housing 310 also includes a third plate body 3103, a fourth plate body 3104 disposed opposite to the third plate body 3103, and a fifth plate body 3105. The fourth plate body 3104 and the fifth plate body 3105 are disposed opposite to the third plate body 3103. The fifth plate body 3105 is positioned closer to the third plate body 3103 than the fourth plate body 3104.

Two opposite edges of the third plate body 3103 are respectively connected to the first plate body 3101 and the second plate body 3102. The fourth plate body 3104 is connected to the second plate body 3102, and the fifth plate body 3105 is connected to the first plate body 3101.

The housing 310 also includes a sixth plate body 3106, and the sixth plate body 3106 is disposed opposite to the second plate body 3102. The sixth plate body 3106 is positioned closer to the second plate body 3102 than the first plate body 3101. The sixth plate body 3106 includes two opposite edges, one of which is connected to an edge of the fourth plate body 3104 away from the second plate body 3102, and the other of which is connected to an edge of the fifth plate body 3105 away from the first plate body 3101. That is, the two opposite edges of the sixth plate body 3106 are respectively connected to the fourth plate body 3104 and the fifth plate body 3105.

For example, the sixth plate body 3106 may be spaced apart from the first plug-in portion 332 in the direction perpendicular to the first circuit board 330.

In addition, the housing 310 further includes a seventh plate body and an eighth plate body disposed opposite to each other. The seventh plate body and the eighth plate body each are connected to the first to sixth plate bodies 3101-3106, and the first to sixth plate bodies 3101-3106 are located between the seventh plate body and the eighth plate body. The first plate body 3101 to the eighth plate body enclose an accommodation cavity.

The first plate body 3101, the third plate body 3103, a portion of the second plate body 3102, a portion of the seventh plate body, and a portion of the eighth plate body may enclose the first accommodation cavity 311. The sixth plate body 3106, the fourth plate body 3104, a portion of the second plate body 3102, the portion of the seventh plate body, and the portion of the eighth plate body may enclose the second accommodation cavity 312.

For example, a width of the sixth plate body 3106 in the first direction F1 may be 29mm, and a width of the sixth plate body 3106 in the second direction F2 may be 50mm. A width of the fourth plate body 3104 in the direction perpendicular to the first circuit board 330 may be 33mm. Therefore, a volume of the second accommodation cavity 312 can be equal to 29mm×50mm×33mm. The first direction F1 extends from the main body portion 331 toward the first plug-in portion 332. The second direction F2 is perpendicular to the first direction F1 and parallel to the first circuit board 330. In FIG. 10, the second direction F2 may be an outward direction perpendicular to the paper surface.

The second accommodation cavity 312 may provide space for disposing the first board portion 3411.

By providing the second accommodation cavity 312 in the housing 310, the space above the first plug-in portion 332 can be utilized effectively, increasing space of the housing 310. In the related art, the space above the first plug-in portion 332 remains idle. Therefore, providing the second accommodation cavity 312 above the first plug-in portion 332 does not occupy space that has been used within the chassis body 100. Therefore, a layout of other components in the chassis body 100 does not need to be changed.

For example, the first board portion 3411 is located on a side of the sixth plate body 3106 facing away from the first plug-in portion 332.

For example, the first plug-in portion 332 of the first circuit board 330 may extend from the fifth plate body 3105. In this case, the fifth plate body 3105 may be the designated plate member.

For example, the input portion 333 of the first circuit board 330 may extend from the third plate body 3103. In this case, the power supply input interface 320 may be provided on a side of the third plate body 3103 facing away from the fourth plate body 3104.

In some examples, a heat dissipation hole 3100 (as shown in FIG. 3) may be provided on the fourth plate body 3104 and/or the fifth plate body 3105 to improve the heat dissipation effect of the power supply 300.

In some examples, the expansion adapter board 350 may be perpendicular to the fourth plate body 3104 and the fifth plate body 3105. The fourth plate body 3104 and the fifth plate body 3105 may be provided with the heat dissipation hole 3100. This configuration prevents the expansion adapter board 350 from obstructing the heat dissipation hole 3100, thereby reducing the heat dissipation impact of the expansion adapter board 350 on the power supply 300.

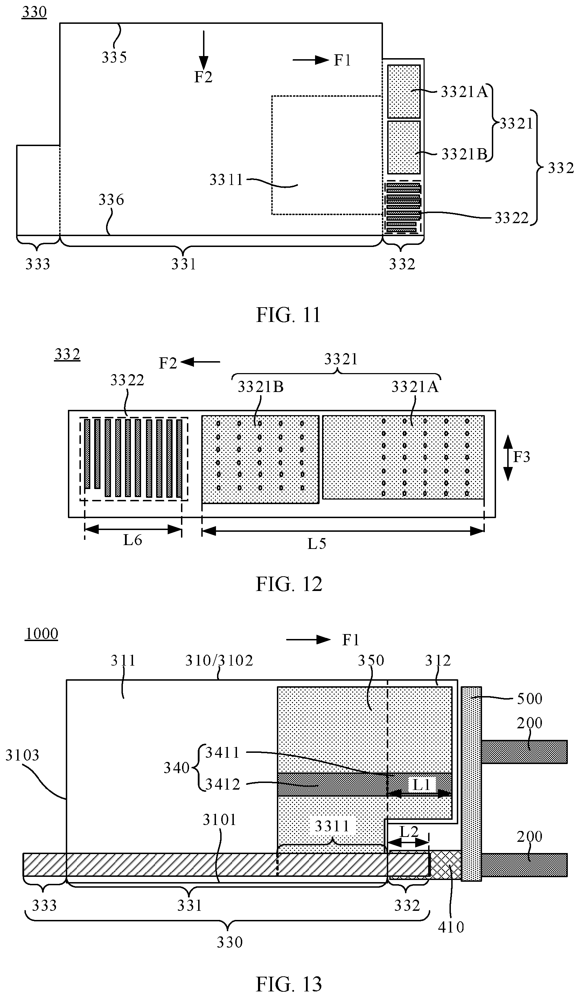

FIG. 11 is a structural schematic diagram of the first circuit board 330 in FIG. 10. The first functional component disposed on the first circuit board 330 are removed in FIG. 11.

As shown in FIG.11, in some embodiments, there are a plurality of first functional components. At least one of the first functional components is disposed in a target region 3311, and the target region 3311 is a region of the main body portion 331 close to the first plug-in portion 332. The first functional component disposed in the target region 3311 includes a first quantity of the first functional component having a height that is less than a minimum height of a first functional component disposed outside the target region 3311. The expansion board 340 is disposed on a side of the first functional component in the target region 3311 facing away from the first circuit board 330. The projection of the expansion board 340 on the first circuit board 330 overlaps at least a portion of the second functional component.

The second direction F2 is parallel to the first circuit board 330 and perpendicular to the first direction F1. In FIG. 11, a direction indicated by an arrow F2 is the second direction.

The target region 3311 includes a plurality of edges. The plurality of edges include a first edge, and the first edge is connected to the first plug-in portion 332.

In some examples, a width of the target region 3311 in the second direction F2 may be less than a width of the main body portion 331 in the second direction F2. In this case, other regions of the main body portion 331 may be disposed around a plurality of edges other than the first edge in the target region 3311.

In some examples, a width of the first plug-in portion 332 in the second direction F2 may be less than the width of the main body portion 331 in the second direction F2. The width of the target region 3311 in the second direction F2 may be equal to the width of the first plug-in portion 332 in the second direction F2.

In some other examples, the width of the target region 3311 in the second direction F2 may be equal to the width of the main body portion 331 in the second direction F2.

The first functional component disposed in the target region 3311 includes the first quantity of the first functional component having a height that is less than the minimum height of the first functional component disposed outside the target region 3311. A height of any one of the first functional component disposed in the target region 3311 is less than the minimum height of a first functional component in other region of the main body portion 331.

For example, a plurality of capacitors may be disposed on the target region 3311. Heights of the capacitors are low and lower than heights of the first functional components on other regions of the main body portion 331. In the related art, a region above the target region 3311 is in an idle state. Therefore, in some of the above embodiments, the second board portion 3412 of the first expansion board 341 is disposed above the target region 3311, so that the orthographic projection of the second board portion 3412 on the first circuit board 330 overlaps the target region 3311, which can further increase the utilizable space inside the power supply 300, reduce the power density of the power supply 300, and improve the heat dissipation effect of the power supply 300.

In addition, due to the low height of the first functional component in the target region 3311, after the second board portion 3412 of the first expansion board 341 is disposed above the target region 3311, a position of a top of the second functional component can be prevented from being too high after the second functional component is disposed on the first expansion board 341, which results in the power supply 300 being too large in size in the direction perpendicular to the first circuit board 330.

In some examples, a side of the second functional component facing away from the first circuit board 330 may be substantially flush with the side of the first functional component facing away from the first circuit board 330. Alternatively, in some other examples, the side of the second functional component facing away from the first circuit board 330 may be lower than the side of the first functional component facing away from the first circuit board 330. With this configuration, a height of the housing 310 of the power supply 300 in the direction perpendicular to the first circuit board 330 can be substantially equal to a height of the housing 310 in the related art in the direction perpendicular to the first circuit board 330. Therefore, space occupied by the power supply 300 in the chassis body 100 can remain unchanged, thus eliminating the need for adjusting the layout of other components in the chassis body 100 for the disposition of the power supply 300 provided in some embodiments of the present application.

As shown in FIG. 11, in some embodiments, the first plug-in portion 332 includes a first plug-in sub-portion 3321 and a second plug-in sub-portion 3322. The first plug-in sub-portion 3321 is spaced apart from the second plug-in sub-portion 3322. The first plug-in sub-portion 3321 is configured to transmit the power supply signal, and the second plug-in sub-portion 3322 is configured to communicate the control signal.

For example, the second plug-in sub-portion 3322 may be electrically connected to the control module. The control module may be connected to an external controller via the second plug-in sub-portion 3322. The control module is configured to send a detection signal or a status signal related to the power supply, receive an external control signal, and based on the control signal, control a voltage processing module within an internal circuitry of the power supply. For example, the external controller may be provided on the second circuit board 200.

For example, the first plug-in sub-portion 3321 may be electrically connected to the voltage processing module. The voltage processing module may output a low-voltage direct current signal through the first plug-in sub-portion 3321. For example, the low-voltage direct current signal may be 12V, 48V, 54V, or other direct current voltage signal.

In some examples, the first plug-in sub-portion 3321 and the second plug-in sub-portion 3322 extend along a same edge of the main body portion 331. For example, the edge may extend along the second direction F2. In this case, the first plug-in sub-portion 3321 and the second plug-in sub-portion 3322 are sequentially disposed along the second direction F2.

The first plug-in sub-portion 3321 is spaced apart from the second plug-in sub-portion 3322, which can avoid a short circuit between the first plug-in sub-portion 3321 and the second plug-in sub-portion 3322.

For example, the first plug-in sub-portion 3321 and the second plug-in sub-portion 3322 may be gold fingers disposed on the first plug-in portion 332.

In some examples, the first plug-in sub-portion 3321 may include a positive electrode region 3321A and a grounding region 3321B spaced apart along an extension direction of an edge of the main body portion 331. The positive electrode region 3321A is spaced apart from the grounding region 3321B, which can prevent a short circuit therebetween. For example, the positive electrode region 3321A and the grounding region 3321B are sequentially disposed along the second direction F2. When the power supply 300 supplies power to the second circuit board 200, voltages of the positive electrode region 3321A and the grounding region 3321B are different.

For example, the grounding region 3321B may be disposed between the positive electrode region 3321A and the second plug-in sub-portion 3322.

FIG. 12 is a planar structural schematic diagram of the first plug-in portion 332 according to some embodiments.

As shown in FIG. 12, the second plug-in sub-portion 3322 may include a plurality of connecting terminals. The plurality of connecting terminals extend along a third direction, and may be sequentially disposed along the third direction. Different connecting terminals may be configured to communicate different control signals. As shown in FIG. 12, a direction indicated by an arrow F3 is the third direction. The third direction is perpendicular to the second direction F2 and parallel to the first plug-in portion 332.

For example, some of the connecting terminals have lengths in the third direction F3 less than lengths of the remaining of the connecting terminals in the third direction F3. Some of the plurality of connecting terminals with longer lengths may be grounding terminals. The grounding terminal is configured to transmit a grounding signal, and the grounding terminal have a greater length, so that the grounding terminal can receive the grounding signal first, thereby reducing signal overshoot.

For example, a width of the grounding region 3321B in the third direction F3 is greater than a width of the positive electrode region 3321Ain the third direction F3.

For example, the first plug-in sub-portion 3321 has a width L5=35mm in the second direction F2. For example, the second plug-in sub-portion 3322 has an effective current flow width L6=13 mm in the second direction F2. The effective current flow width refers to a width in the second direction F2, of a portion of the second plug-in sub-portion 3322 provided with the gold fingers.

FIG. 13 is a schematic diagram of a structure when the power supply 300 shown in FIG. 10 is electrically connected to the second circuit board 200.

As shown in FIG. 13, in some embodiments, the computing device 1000 further includes a first plug-in connector 410. One end of the first plug-in connector 410 may be electrically connected to the second circuit board 200. The other end of the first plug-in connector 410 may be plugged into and electrically connected to the first plug-in portion 332.

For example, the first plug-in connector 410 is provided with an accommodation slot, and when the first plug-in connector 410 is plugged into the first plug-in portion 332, the first plug-in portion 332 may be disposed within the accommodation slot.

In some embodiments, in the first direction F1, an end of the first board portion 3411 extends beyond an end of the first plug-in portion 332.

In the first direction F1, the end of the first board portion 3411, refers to an end of the first board portion 3411 facing away from the second board portion 3412. The end of the first plug-in portion 332 in the first direction F1 refers to an end of the first plug-in portion 332 facing away from the main body portion 331.

The end of the first board portion 3411 extending beyond the end of the first plug-in portion 332 in the first direction F1 can be understood as follows: an orthographic projection of an end of the first board portion 3411 away from the housing 310 on the first circuit board 330 is located at a side of the first plug-in portion 332 away from the main body portion 331. Additionally, it can also be understood that a width L1 of the first board portion 3411 in the first direction F1 is greater than a width L2 of the first plug-in portion 332 in the first direction F1.

A length of the first plug-in connector 410 in the first direction F1 is greater than a length of the first plug-in portion 332 in the first direction F1. When the first plug-in portion 332 is plugged into the first plug-in connector 410, at least a portion of the first plug-in connector 410 may be located below the first board portion 3411. Therefore, disposition of the first expansion board 341 can also utilize space above the first plug-in connector 410, thereby increasing utilizable space in the housing 310 of the power supply 300, enlarging the volume of the power supply 300, thus reducing the power density of the power supply 300 and improving the heat dissipation effect of the power supply 300.

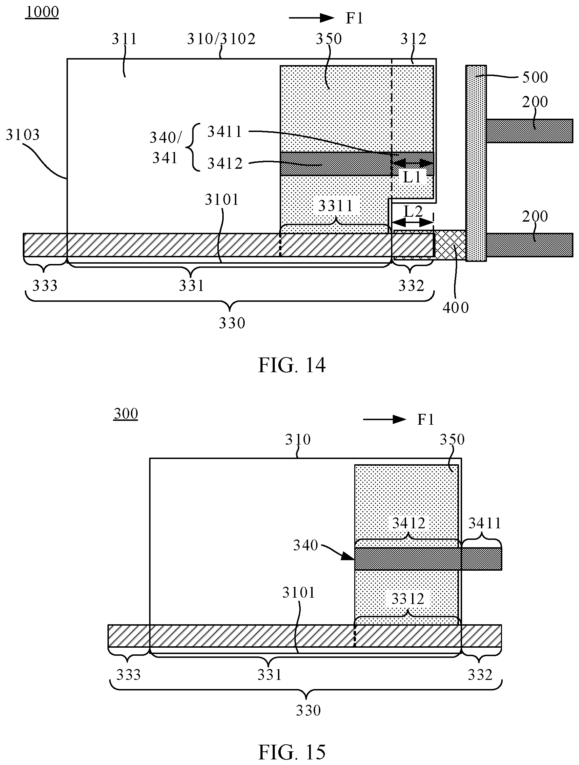

FIG. 14 is yet another structural schematic diagram of the computing device 1000 according to some embodiments of the present application.

As shown in FIG. 14, in some other embodiments, in the first direction F1, the end of the first board portion 3411 away from the second board portion 3412 is flush with the end of the first plug-in portion 332 away from the main body portion 331. In this case, the width L1 of the first board portion 3411 in the first direction F1 is equal to the width L2 of the first plug-in portion 332 in the first direction F1.

As shown in FIGS. 13 and 14, in some embodiments, the computing device 1000 may further include: a power adapter board 500. The power adapter board 500 is electrically connected to the second circuit board 200, and the first plug-in connector 410 may be disposed on a side of the power adapter board 500 facing away from the second circuit board 200, and is electrically connected to the power adapter board 500. The first plug-in connector 410 is plugged into and electrically connected to the first plug-in portion 332.

In some examples, the power adapter board 500 may be connected to at least one second circuit board 200, thereby enabling the power supply 300 to supply power to the at least one second circuit board 200 and components disposed thereon. In FIGS. 13 and 14, the power adapter board 500 is shown connected to two second circuit boards 200 to illustrate embodiments of the present application.

In a case where there are a plurality of second circuit boards 200, the plurality of second circuit boards 200 may be disposed in parallel.

For example, the second circuit board 200 may be disposed perpendicular to the power adapter board 500.

For example, the power adapter board 500 may be disposed perpendicular to the first circuit board 330.

In some examples, the computing device 1000 may include a plurality of power supplies 300. In this case, a plurality of first plug-in connectors 410 may be disposed on the power adapter board 500. The plurality of first plug-in connectors 410 may be respectively plugged into the first plug-in portions 332 of the plurality of power supplies 300. Thus, the plurality of power supplies 300 may be electrically connected to at least one second circuit board 200 through the plurality of first plug-in connectors 410 and the power adapter board 500, so that the plurality of power supplies 300 may supply power to the at least one second circuit board 200.

In some of the above embodiments, by disposing the plurality of power supplies 300 in the computing device 1000, when some of the power supplies 300 fail, remaining power supplies 300 may continue supplying power to components in the computing device 1000, thereby ensuring normal operation of the computing device 1000.

The plurality of power supplies 300 may be disposed side by side on the bottom plate of the chassis body 100 or may be stacked sequentially on the bottom plate of the chassis body 100.

In some of the above embodiments, the first board portion 3411 and the second board portion 3412 are disposed within the housing, and the second functional component is disposed on the first board portion 3411 and the second board portion 3412.

FIG. 15 is another structural schematic diagram of the power supply 300 according to some embodiments.

As shown in FIG. 15, in some other embodiments, the second functional component may be disposed on the second board portion 3412. The first board portion 3411 is configured as a second plug-in portion, and the second plug-in portion is electrically connected to the external second circuit board 200. The first plug-in portion is configured to transmit the power supply signal, and the second plug-in portion is configured to communiate the control signal. In this case, the first board portion 3411 serving as the second plug-in portion can extend from the housing 310.

In some examples, the orthographic projection of the first board portion 3411 on the first circuit board 330 overlaps the first plug-in portion 332. In this case, the orthographic projection of the first board portion 3411 on the first circuit board 330 may partially overlap the first plug-in portion 332, or the orthographic projection of the first board portion 3411 on the first circuit board 330 may completely overlap the first plug-in portion 332.

The first plug-in portion 332 may be electrically connected to the voltage processing module, and the voltage processing module may output the low-voltage direct current signal through the first plug-in portion 332.

The first board portion 3411 may be electrically connected to the control module, and the control module may be electrically connected to the external controller via the first board portion 3411 to receive the control signal from the external controller and control the voltage processing module based on the control signal. For example, the external controller may be disposed on the second circuit board 200, and the first board portion 3411 may be electrically connected to the second circuit board 200, so that the control module may receive the control signal through the first board portion 3411.

In some examples, a distance between the end of the first board portion 3411 away from the second board portion 3412 and the housing 310 may be equal to a distance between the end of the first plug-in portion 332 away from the main body portion 331 and the housing 310.

The distance between the end of the first board portion 3411 away from the second board portion 3412 and the housing 310 can be understood as the width of the first board portion 3411 in the first direction F1. The distance between the end of the first plug-in portion 332 away from the main body portion 331 and the housing 310 can be understood as a width of the first plug-in portion 332 in the first direction F1.

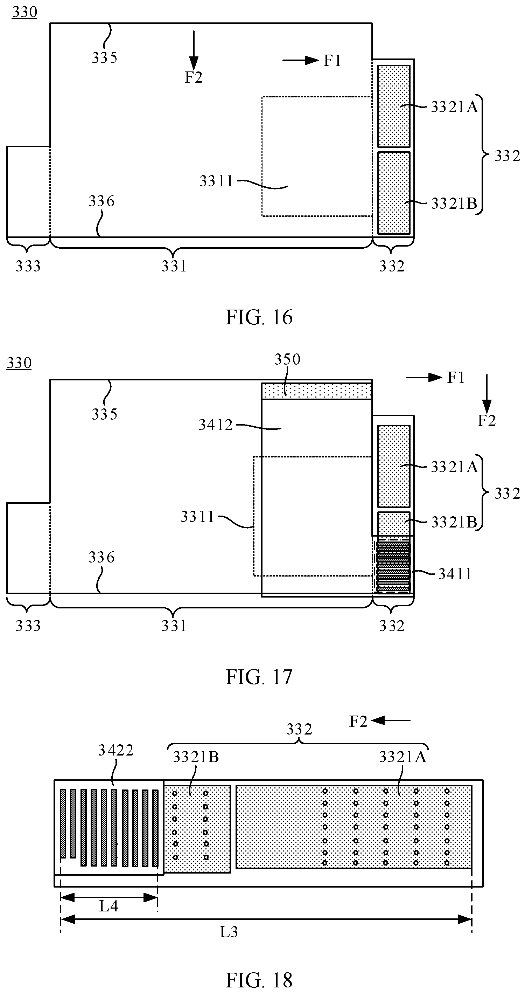

FIG. 16 is a structural schematic diagram of the first circuit board 330 in FIG. 15. The first functional component disposed on the first circuit board 330 are removed in FIG. 16.

As shown in FIG. 16, in some examples, the first plug-in portion 332 may include the positive electrode region 3321A and the ground region 3321B. The positive electrode region 3321A is configured to transmit a positive voltage signal, and the grounding region 3321B is configured to transmit a grounding signal.

In some of the above embodiments, the second plug-in portion for communicating the control signal and the first plug-in portion 332 for transmitting the power supply signal are respectively disposed on the expansion board 340 and the first circuit board 330, thus allowing the width of the first plug-in portion 332 in the second direction F2 to be designed larger, thereby increasing a current flow area for the power supply signal.

FIG. 17 is a top view of the first circuit board 330 shown in FIG. 15 connected to the expansion board 340.

As shown in FIG. 17, in some examples, the orthographic projection of the first board portion 3411 on the first circuit board 330 may partially overlap the first plug-in portion 332.

In some examples, the orthographic projection of the first board portion 3411 on the first circuit board 330 may be located at an end of the first plug-in portion 332 in the second direction F2. In this case, an orthographic projection of an end of the first board portion 3411 in the second direction F2 on the first circuit board 330 may overlap with an end of the first plug-in portion 332 in the second direction F2.

In some other examples, the orthographic projection of the first board portion 3411 on the first circuit board 330 may be located at the middle of the first plug-in portion 332.

FIG. 18 is a structural schematic diagram of the orthogonal projection of the first board portion 3411 in FIG. 17 onto the first plug-in portion 332. In FIG. 18, the main body portion 331 of the first circuit board 330 and the second plate portion 3412 of the expansion board 340 are not shown.

As shown in FIG. 18, in some examples, the width of the first plug-in portion 332 in the second direction F2 is L3, and an effective current flow width of the first board portion 3411 in the second direction F2 is L4. The effective current flow width refers to a width in the second direction F2, of a portion of the first board portion 3411 provided with the gold fingers, where L3 is greater than L4.

For example, 3×L4≤L3≤4.5×L4.

By configuring the width L3 of the first plug-in portion 332 in the second direction F2 to be greater than or equal to 3×L4, it can be avoided that a current flow width of the power supply signal is too small due to a too small width L3 of the first plug-in portion 332 in the second direction F2. In addition, a width of the first circuit board 330 in the second direction F2 is positively correlated with the width L3 of the first plug-in portion 332 in the second direction F2. By configuring the width L3 of the first plug-in portion 332 in the second direction F2 to be ≤4.5×L4, it can be avoided that the width of the first circuit board 330 in the second direction F2 being too large due to a too large width L3 of the first plug-in portion 332 in the second direction F2, thereby preventing the volume of the power supply 300 from being too large.

For example, L4=3.8×L3.

For example, L4=13mm; L3=49.5mm.

In some other examples, the width L3 of the first plug-in portion 332 in the second direction F2 may be equal to the effective current flow width of the first board portion 3411 in the second direction F2.

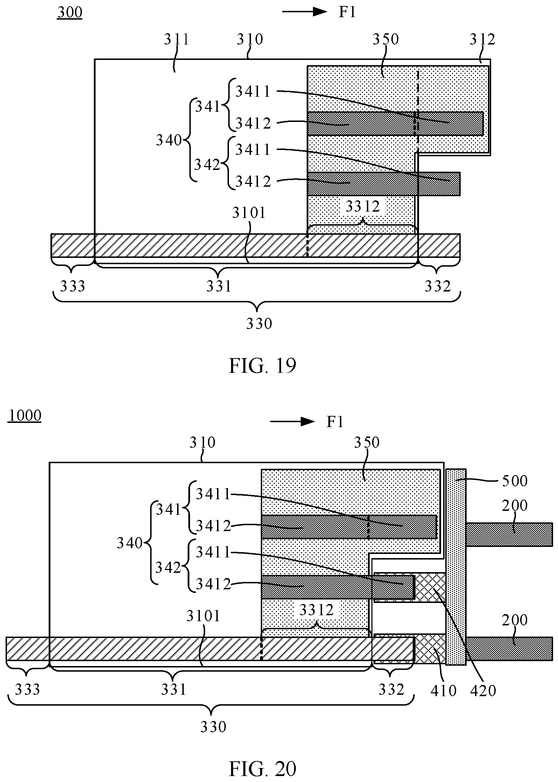

FIG. 19 is another structural schematic diagram of the power supply 300 according to some embodiments.

As shown in FIG. 19, in some embodiments, the power supply 300 may include a plurality of expansion boards 340. For example, the plurality of expansion boards 340 include a first expansion board 341 and a second expansion board 342. The second expansion board 342 is located between the first expansion board 341 and the first circuit board 330. The first board portion 3411 of the second expansion board 342 is configured as the second plug-in portion, and the second board portion 3412 of the second expansion board 342 is located in the housing 310. The first board portion 3411 and the second board portion 3412 of the first expansion board 341 are located in the housing 310. The second plug-in portion is configured to communicate the control signal, and the first plug-in portion 332 is configured to transmit the power supply signal.

In this case, the housing 310 may enclose the first accommodation cavity 311 and the second accommodation cavity 312. The first board portion 3411 of the first expansion board 341 is disposed in the second accommodation cavity 312, and the second board portion 3412 is disposed in the first accommodation cavity 311.

The second board portion 3412 of the second expansion board 342 is located in the first accommodation cavity 311, and the first board portion 3411 extends from the housing 310.

The plurality of second functional components may include a first portion of second functional components and a second portion of second functional components. The first portion of second functional components are disposed on the first board portion 3411 and the second board portion 3412 of the first expansion board 341, while the second portion of second functional components are disposed on the second board portion 3412 of the second expansion board 342.

In some examples, a width of the first board portion 3411 of the first expansion board 341 in the first direction F1 may be greater than a width of the first board portion 3411 of the second expansion board 342 in the first direction F1. In this case, an area of the first board portion 3411 of the first expansion board 341 is larger, thereby providing greater utilizable space for the disposition of the second functional component.

In some examples, some of the second functional components may be disposed on the first board portion 3411 of the second expansion board 342. In other examples, no functional component may be disposed on the second expansion board 342. In this case, it can be prevented that the functional component on the second expansion board 342 obstructs the heat dissipation opening 3100, thereby affecting heat dissipation of the power supply 300.

In some other examples, the width of the first board portion 3411 of the first expansion board 341 in the first direction F1 may be less than or equal to the width of the first board portion 3411 of the second expansion board 342 in the first direction F1.

In some examples, a width of the second board portion 3412 of the first expansion board 341 in the first direction F1 may be greater than a width of the second board portion 3412 of the second expansion board 342 in the first direction F1. In this case, a small number of second functional components may be disposed on the second board portion 3412 of the second expansion board 342. In this example, since the width of the second board portion 3412 of the second expansion board 342 in the first direction F1 is small, space occupied by the second board portion 3412 of the second expansion board 342 inside the housing 310 can be reduced. In addition, due to a small distance between the second board portion 3412 of the second expansion board 342 and the first circuit board 330, and a small width of the second board portion 3412 of the second expansion board 342, an interference between the second board portion 3412 of the second expansion board 342 and a first functional component on the main body portion 331 of the first circuit board 330 can be avoided.

In some other examples, the width of the second board portion 3412 of the first expansion board 341 in the first direction F1 may be less than or equal to the width of the second board portion 3412 of the second expansion board 342 in the first direction F1.

FIG. 20 is a schematic diagram of a structure when the power supply 300 shown in FIG.19 is electrically connected to the second circuit board 200.

As shown in FIG. 20, when the power supply 300 includes the second plug-in portion, the computing device 1000 further includes: a second plug-in connector 420. The second plug-in connector 420 is disposed on the side of the power adapter board 500 facing away from the second circuit board 200, and is electrically connected to the power adapter board 500. The first plug-in connector 410 is spaced apart from the second plug-in connector 420. The second plug-in connector 420 is plugged into and electrically connected to the second plug-in portion.

The first plug-in connector 410 has been introduced above, and will not be repeated here.

For example, the second plug-in connector 420 may be provided with a second plug-in slot. When the second plug-in connector 420 is electrically connected to the second plug-in portion, the second plug-in portion may be located within the second plug-in slot.

An assembly formed by the first plug-in connector 410, the second plug-in connector 420, and the power adapter board 500 in FIG. 20 may also be applied to the power supply 300 in FIG. 8, where the power supply 300 includes the second plug-in portion.

The above descriptions are only implementations of the present application, but the protection scope of the present application is not limited here. Any changes or substitutions conceived by those skilled in the art within the technical scope disclosed in the present application shall fall within the protection scope of the present application. Therefore, the protection scope of the present application shall be subject to the protection scope of the claims.

## Claims

1. A power supply, comprising: a first circuit board, an expansion board, and a plurality of functional components;
wherein the first circuit board comprises a main body portion and a first plug-in portion located at an end of the main body portion, wherein the first plug-in portion is electrically connectableto an external second circuit board; the expansion board is disposed at the main body portion and electrically connected to the main body portion; wherein a projection of the expansion board on the first circuit board overlaps at least a portion of the first plug-in portion; and
the plurality of functional components comprise a first functional component and a second functional component, wherein the first functional component is disposed on the main body portion and electrically connected to the main body portion, and the second functional component is disposed on the expansion board and electrically connected to the expansion board.

2. The power supply according to claim 1, wherein the expansion board comprises a first board portion and a second board portion, and the first board portion is electrically connected to the second board portion; wherein the first board portion is disposed opposite to the first plug-in portion; and the second board portion is disposed opposite to the main body portion.

3. The power supply according to claim 2, wherein
the second functional component is disposed on the second board portion; the first board portion is configured as a second plug-in portion, and the second plug-in portion is electrically connectable to the external second circuit board;
wherein the first plug-in portion is configured to transmit a power supply signal; and the second plug-in portion is configured to communicate a control signal.

4. The power supply according to any one of claims 1 to 3, wherein the second functional component comprises a controller of the power supply.

5. The power supply according to claim 1 or 2, wherein
the first plug-in portion comprises a first plug-in sub-portion and a second plug-in sub-portion, and the first plug-in sub-portion is spaced apart from the second plug-in sub-portion; wherein the first plug-in sub-portion is configured to transmit a power supply signal, and the second plug-in sub-portion is configured to communicate a control signal.

6. The power supply according to any one of claims 1 to 5, wherein
there are a plurality of first functional components; wherein at least one of the first functional components is disposed in a target region, and the target region is a region of the main body portion close to the first plug-in portion; the first functional component disposed in the target region comprises a first quantity of the first functional component having a height less than a minimum height of a first functional component disposed outside the target region;
the expansion board is disposed on a side of the first functional component in the target region facing away from the first circuit board; and the projection of the expansion board on the first circuit board overlaps at least a portion of the second functional component.

7. The power supply according to any one of claims 1 to 6, wherein
the power supply further comprises an expansion adapter board; and
the expansion board is disposed at the main body portion via the expansion adapter board, and is electrically connected to the main body portion.

8. The power supply according to claim 1, wherein
the power supply further comprises an adapter connector; and
the expansion board is disposed at the main body portion via the adapter connector, and is electrically connected to the main body portion.

9. A computing device, comprising at least one power supply according to any one of claims 1 to 8 and at least one second circuit board;
wherein the first plug-in portion is electrically connected to the second circuit board.

10. The computing device according to claim 9, further comprising: a power adapter board and a first plug-in connector; wherein the power adapter board is electrically connected to the second circuit board;
the first plug-in connector is disposed on a side of the power adapter board facing away from the second circuit board, and is electrically connected to the power adapter board; and the first plug-in connector is configured to be plugged into and electrically connected to the first plug-in portion.

11. The computing device according to claim 10, further comprising: a second plug-in connector;
wherein the second plug-in connector is disposed on the side of the power adapter board facing away from the second circuit board, and is electrically connected to the power adapter board; the first plug-in connector is spaced apart from the second plug-in connector; and the second plug-in connector is configured to be plugged into and electrically connected to the second plug-in portion.
